# EUROPEAN PATENT SPECIFICATION

(11) **EP 3 505 771 B1**
(45) Date of publication and mention of the grant of the patent: **10.11.2021**
(21) Application number: 18177940.6
(22) Date of filing: 15.06.2018
(51) Int. Cl.: F04D 25/14, F04D 19/00, F04D 25/16, F04D 29/54, H05K 7/20

(54) **ANTI-REVERSE FLOW COOLING FAN ASSEMBLY**
KÜHLGEBLÄSEANORDNUNG MIT RÜCKFLUSSSCHUTZVORRICHTUNG
ENSEMBLE DE VENTILATEUR DE REFROIDISSEMENT AVEC DISPOSITIF ANTI-REFOULEMENT

(30) Priority: 29.12.2017 US 201762611695 P; 03.04.2018 US 201815944165
(43) Date of publication of application: 03.07.2019
(73) Proprietor: Quanta Computer Inc., Taoyuan City 333 (TW)
(72) Inventor: CHEN, Chao-Jung, Taoyuan City 333 (TW); HUANG, Yu-Nien, Taoyuan City 333 (TW); CHEN, Ching-Yu, Taoyuan City 333 (TW); LIAO, Kuan-Hsiang, Taoyuan City 333 (TW)
(74) Representative: Winter, Brandl - Partnerschaft mbB

(56) References cited:
- DE-A1-102010 048 451
- ES-A1- 2 234 348
- US-A- 3 263 906
- US-A- 3 334 569
- US-A1- 2005 016 595
- US-A1- 2006 152 901
- US-A1- 2008 056 900
- US-A1- 2008 160 896

## Description

### FIELD OF THE INVENTION

The present invention relates to cooling fan assemblies, and more specifically to cooling fan assemblies with anti-reverse flow features.

### BACKGROUND

Computer systems typically include a large number of computer components, such as processors, graphic cards, power supplies, and memory modules. Typically, most of these components produce heat while being operated, and need to be kept within a certain temperature range in order to prevent over-heating. Consequently, computer systems typically incorporate cooling fans that circulate air over the components. In most computer systems, the cooling fans and the components are arranged so that the air circulating in the computer system carries heat away from the components and out of the computer system.

In some computer system designs, multiple fans can be provided to cool the computer system. For example, the multiple fans can be placed side-by-side across the width of the computer system to provide a uniform airflow through the computer system. However, if one of the fans fails or stops rotating for any reason, then the airflow through the computer system will no longer be uniform. This can lead to overheating of one or more components.

Some computer systems rely on the placement of louvers or shutters next to each fan in order to maintain a uniform airflow even when one or more fans are non-operational. The shutters can also be closed when the fan is non-operational. However, such louvers or shutters typically require additional space next to the fan. This additional space for the louvers or shutters takes up valuable physical storage space and adds unfavorable bulk to computer systems. Moreover, such shutters or louvers can also obstruct the flow of cooling air from the fan to the hardware components. Even worse, reverse airflow through the non-operational fan can occur, further reducing the amount of airflow being provided to downstream components. For example, in ES 2 234 348 A1, an extractor is disclosed comprising a structure that houses an impeller that forms a helix with blades and a support with hinged blades that are also directives. In a sealing position, the vanes are folded down on themselves preventing the passage of air, and in an open position they are raised to allow air flow. Said pallets comprise a fixed part and a moving part designed to redirect the air exiting the propeller providing an outflow in a direction parallel to that of rotation of said helix. Further, in US 2006/152901 A1, a dynamically adaptable electronics cooling fan and a method for operating said cooling fan by rotating an impeller about a rotational axis and detecting fan failure are disclosed. Thereby, the impeller is spatially expanded in response to the detected fan failure whereby airflow through the failed fan is blocked. Furthermore, DE 10 2010 048451 A1 discloses a partitioning device for partitioning of a radiator fan module of a radiator of a motor vehicle. The partitioning device comprises an inner ring, and multiple fan units, which are extending outwards from the inner ring. The fan unit comprises a primary fan element and a secondary fan element connected with the primary fan element. A drive unit is formed, such that the fan elements are folded in a primary mode and are unfolded in a secondary mode. Moreover, US 3,334,569 A discloses a powered extraction fan with a non-return shutter assembly comprising shutters hinged on axes radiating from the centre of the assembly. The shutters all open in the same sense so as to present the minimum resistance to the air flow. Additionally, in US 2005/016595 A1, a reverse flow preventing device arranged in a flow path by a fan and an electronic apparatus equipped with the same is disclosed. The reverse flow preventing device has a frame, a plurality of support shafts arranged about the center of the frame and mounted on the frame, and a plurality of pivotable plate members supported by the support shafts. The plate members can move between the first position (reverse flow preventing position) in which they lie in a substantially single plane and the second position (normal operating position) in which they move. The support shafts and the plate members are arranged substantially concentrically or radially.

What is needed is a cooling fan that minimally obstructs the air current over hardware components and that can quickly and easily be covered when the fan is non-operational, thereby preventing the flow of air through the fan in the reverse direction.

### SUMMARY

The present invention is directed towards a cooling fan assembly as defined in claim 1 which prevents the reverse flow of air through the fan. The cooling fan assembly includes a housing for the cooling fan that contains an inlet and an outlet. The housing is comprised of a shroud panel disposed at the outlet. An axial fan is disposed in the housing and configured to draw air from the inlet to the outlet. The shroud panel comprises a plurality of cutout portions disposed along an airflow of the axial fan. A plurality of fixed members separates the cutout portions. Flap members are pivotably attached to each of the fixed members. Each flap member is configured to alternate between at least two possible positions. In the first position, a flap member extends away from the shroud panel. In the second position, a flap member lies within one of the plurality of cutout portions. Further, at least one spring-loaded structure is configured as a pivot connected between each one of the plurality of flap members and the associated one of the plurality of fixed members. This spring-loaded structure is configured to maintain an associated flap member in the second position when the axial fan fails to supply a threshold amount of airflow. When in the second position, the flap members are configured to extend substantially across an associated cutout portion.

In a first embodiment, each of the plurality of flap members and associated fixed members are configured to define a static blade in the shroud panel.

In another embodiment, the plurality of cutout portions extends along the shroud panel in an annular path.

In another embodiment, at least one of the plurality of flap members or an associated one of the plurality cutout portions includes one or more sealing elements.

In another embodiment, each of the plurality of flap members is configured to alternate from the first position to the second position, in response to airflow from the inlet to the outlet. The flap members alternate from the second position to the first position in response to airflow from the outlet to the inlet.

Throughout the present disclosure, the terms "personal computer", "server system", "laptop computer", "computer system", and "tablet" can be used interchangeably to identify any electronic computing system which can use a fan to cool overheating electronic components.

### BRIEF DESCRIPTION OF THE DRAWINGS

FIG. 1A shows a schematic side view of a fan assembly in a conventional design.
FIG. 1B shows a schematic view of the inlet side of the fan assembly of FIG. 1A.
FIG. 1C shows a schematic view of the outlet side of the fan assembly of FIG. 1A.
FIG. 2A shows a side view of a cooling fan according to an embodiment which does not form part of the present invention.
FIG. 2B shows a side view of a cooling fan when a set of flap blades is configured to prevent air from flowing through the cooling fan, according to an embodiment which does not form part of the present invention.
FIG. 3A shows a schematic design of a cooling fan where a set of flap blades is configured to allow air to flow through the cooling fan, according to an embodiment of the present invention.
FIG. 3B shows a schematic design of a cooling fan where a set of flap blades is configured to prevent air from flowing through the cooling fan, according to an embodiment of the present invention.
FIG. 3C shows a side view of a cooling fan where a set of flap blades is configured to allow air to flow through the cooling fan, according to an embodiment of the present invention.
FIG. 3D shows a side view of a cooling fan where a set of flap blades is configured to prevent air from flowing through the cooling fan, according to an embodiment of the present invention.
FIG. 4 shows a diagram of an exemplary configuration of cooling fan assemblies according to the invention in a computer system.

### DETAILED DESCRIPTION

The present invention is described with reference to the attached figures, wherein like reference numerals are used throughout the figures to designate similar or equivalent elements. The figures are not drawn to scale and they are provided merely to illustrate the instant invention. Several aspects of the invention are described below with reference to example applications for illustration. It should be understood that numerous specific details, relationships, and methods are set forth to provide a full understanding of the invention. One having ordinary skill in the relevant art, however, will readily recognize that the invention can be practiced without one or more of the specific details or with other methods. In other instances, well-known structures or operations are not shown in detail to avoid obscuring the invention. However, the scope of the present invention is solely defined by the appended claims.

The present invention is directed to an assembly for a cooling fan that allows air to flow through the cooling fan in substantially only the intended direction. The cooling fan can be placed in a personal computer, a server system, a laptop computer, a tablet, or any other electronic computing system. As discussed above, current cooling fans do not provide an assembly sufficient to maintain uniform airflow without additional parts, a bulky design, or allowing air to flow through the reverse direction of the cooling fan.

In view of limitations of present cooling fans, the present invention provides a cooling fan assembly designed with anti-reverse flow features. In particular, the cooling fan assembly includes anti-reverse flow members. These anti-reverse flow members are lifted into a first position by the positive pressure of the fan when the fan is in operation, thereby allowing airflow through the fan. If the fan is not operational, the anti-reverse flow members are configured to move into a second position and block a reverse airflow through the non-operational fan.

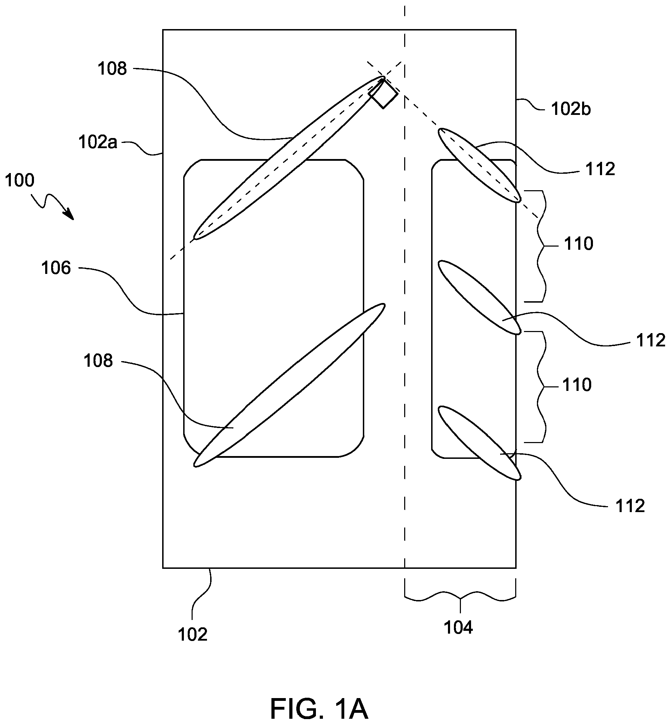

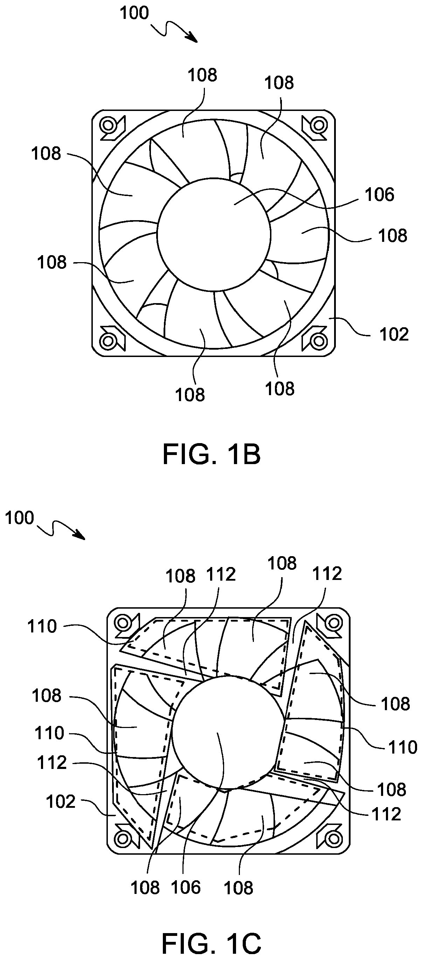

FIG. 1A-1C show a cooling fan assembly 100 according to a conventional design which includes a fan housing 102 with an inlet 102a and an outlet 102b, a shroud panel 104, an axial fan 106, fan blades 108, cutout portions 110, and static blades 112. In particular, FIG. 1A shows a schematic side view of fan assembly 100. FIG. 1B shows a schematic view of the inlet side of fan assembly 100. FIG. 1C shows a schematic view of the outlet side of fan assembly 100.

The shroud panel 104 contains the outlet 102b through which air passes on its way out of the fan assembly 100. As shown in FIGs. 1A and 1C, the shroud panel 104 is comprised of static blades 112 and cutout portions 110, and is located on the exterior of the cooling fan assembly 100. An axial fan 106 directs air through the fan assembly 100 from the inlet 102a to the outlet 102b. The axial fan 106 includes a number of fan blades 108. In operation, the axial fan 106 rotates the fan blades 108, which in turn pulls air through the inlet 102a and pushes air through the outlet 102b. At the outlet 102b, the air flowing through the fan assembly 100 goes through the cutout portions 110 of the shroud panel 104, and is further directed by the static blades 112. The static blades 112 can be angled, relative to the fan blades 108. For example, as shown by the dotted lines in FIG 1A, the static blades 112 can be angled at 90 degrees with respect to the fan blades 108.

One of the issues with the fan assembly 100 is that in the event that axial fan 106 stops rotating, there is no mechanism in the fan assembly 100 to prevent reverse airflow, i.e., airflow from the outlet 102b back into the inlet 102a. This issue is resolved with the new fan assembly design discussed below.

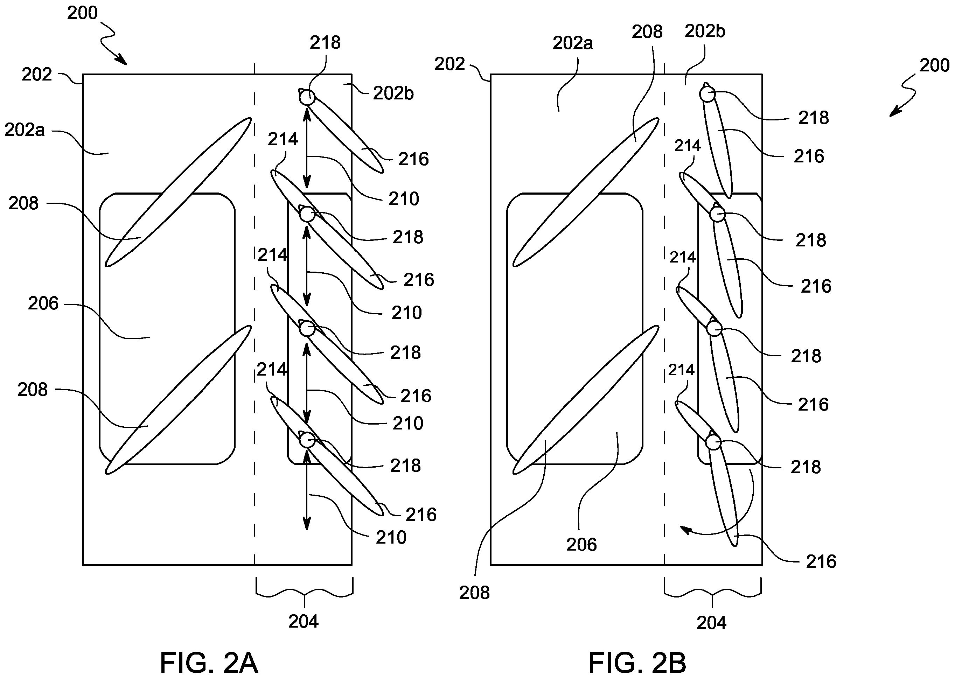

FIG. 2A and FIG. 2B show a fan assembly 200 according to an exemplary embodiment which does not form part of the present invention. The fan assembly 200 includes a fan housing 202 with an inlet 202a and an outlet 202b, a shroud panel 204, an axial fan 206, fan blades 208, cutout portions 210, fixed members 214, flap members 216, and biasing elements 218. In operation, the flap members 216 are configured to alternate between an extended or open position (as shown in FIG. 2A), and a retracted or closed position (as shown in FIG. 2B). In the extended or open position of FIG. 2A, air is able to flow through the fan assembly 200. In the retracted or closed position of FIG. 2B, the flap members 216 are configured to block airflow through the fan assembly 200, including any reverse airflow from the outlet 202b to the inlet 202a. This is discussed in greater detail below.

Like fan assembly 100 in FIGs. 1A-1C, the fan housing 202 in FIGs. 2A-2B has an inlet 202a where air passes into the fan assembly 200, and an outlet 202b where air passes out of the fan assembly 200. In particular, the rotation of the fan blades 208 pulls air through the inlet 202a, and pushes air through the shroud panel 204 and out of the fan assembly 200 through the outlet 202b. As shown in FIGs. 2A and 2B, the shroud panel 204 contains a structure including cutout portions 210, fixed members 214, and flap members 216.

Like the shroud panel 104 of FIGs. 1A-1C, the shroud panel 204 of FIGs. 2A and 2B includes fixed members 214 that are stationary and separated by a series of cutout portions 210. Thus, the position of the fixed members 214 remains unchanged regardless of the direction of airflow through the fan assembly 200. However, according to the present invention, fixed members 214 have attached thereto flap members 216. However, in some embodiments which do not form part of the present invention and as shown in FIG. 2A and 2B, some flap members 216 may not have corresponding fixed members 214. For example, a flap member 216 without a corresponding fixed member 214 is shown by the flap member 216 at the top of FIG. 2A and the top of FIG. 2B. In operation, the flap members 216 alternate between the extended or open position (as shown in FIG. 2A), and a retracted or closed position (as shown in FIG. 2B). In the configuration of FIGs. 2A and 2B, each of the flap members 216 is associated with at least one of the cutout portions 210. In particular, each of the flap members 216 is configured to block one of the cutout portions 210 in the retracted or closed position. In this manner, airflow, including reverse airflow, through the fan assembly 200 is blocked in the retracted or closed position.

As shown in FIGs. 2A and 2B, biasing elements 218 are provided on the flap members 216, and are used to attach the flap member 216 to the fixed member 214. Biasing elements 218 are configured to serve as a pivot so that flap members 216 can rotate between the open position shown in FIG. 2A and the closed position shown in FIG. 2B. According to the invention, the biasing elements 218 are a spring-loaded structure, and are configured to respond to positive airflow (from the inlet 202a to the outlet 202b) through the fan assembly 200. In such configurations, the spring-loaded structure of the biasing elements 218 is configured to bias the flap members 216 towards their respective cutout portions 210. In other embodiments outside the scope of the invention, the biasing elements 218 can be a gravity or weight driven structure configured to respond to positive airflow through the fan assembly 200. In such configurations, select portions of the flap members 216 can be configured to have weighted portions so that in the absence of positive airflow, the weighted portions cause the flap members 216 to be biased towards their respective cutout portions 210.

In some implementations, the shape of the fixed members 214 and the flap members 216 can be selected so that in the open position, a fixed member 214 and an associated flap member 216 define a static blade portion, similar to the static blade 112 in fan assembly 100.

In some implementations, sealing elements can also be provided. That is, the flap members 216, the cutout portions 210, or both, can include sealing elements to further reduce airflow in the closed position. For example, a flap member 216 can include a flexible edge around its perimeter so that when the flap member 216 is in the closed position, the airflow is more effectively blocked. Similarly, the cutout portions 210 can include similar features.

Although the implementations herein show one flap member 216 associated with one cutout portion 210, the various embodiments are not limited in this regard. In some implementations, the multiple flap members 216 can be associated with the same cutout portion 210. Thus, blocking of airflow through the one cutout portion 210 is provided when the associated flap members 216 are all in the closed position.

In FIG. 2A, the flap members 216 and their corresponding fixed members 214 are separated at regular intervals by cutout portions 210. However, the various embodiments are not limited in this regard, and the fixed members 214 can separate the cutout portions 210 at irregular intervals.

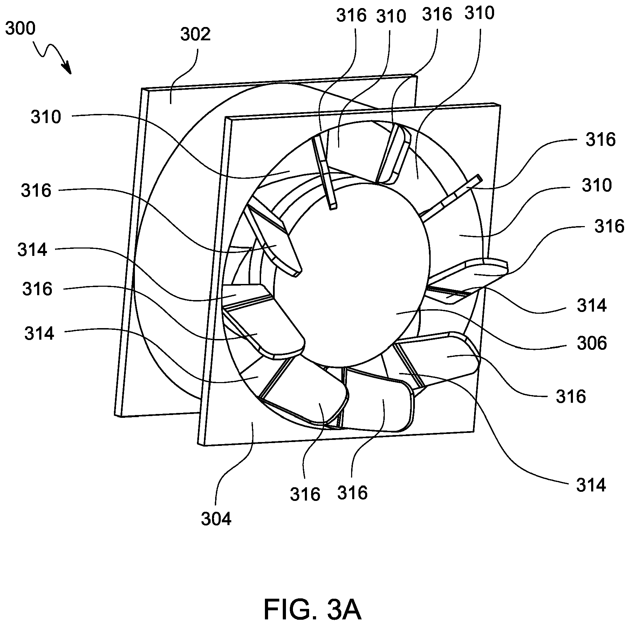

FIGs. 3A -- 3D show a fan assembly 300 according to an exemplary embodiment of the present invention where the fan is configured to allow airflow across electronic components. The fan assembly 300 is shown only for illustrative purposes and not by way of limitation.

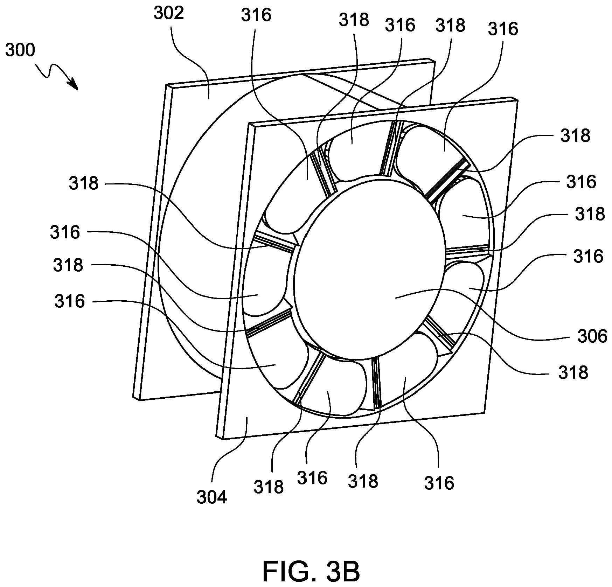

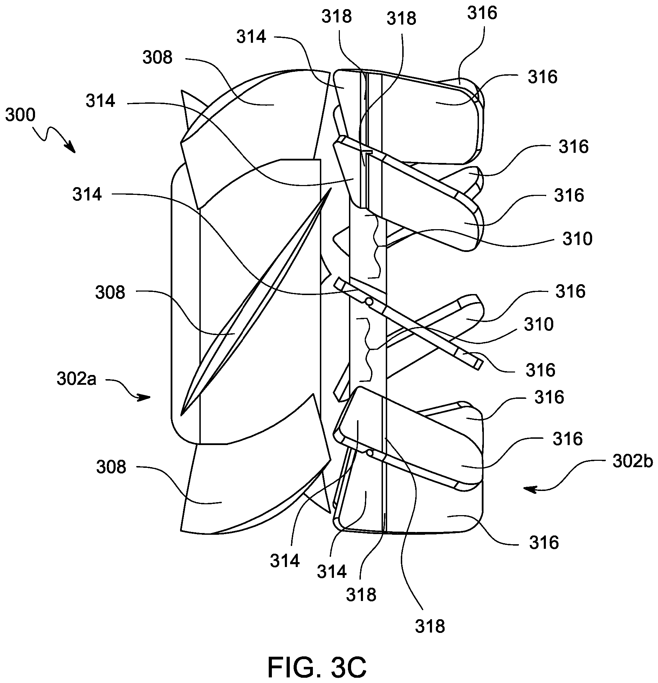

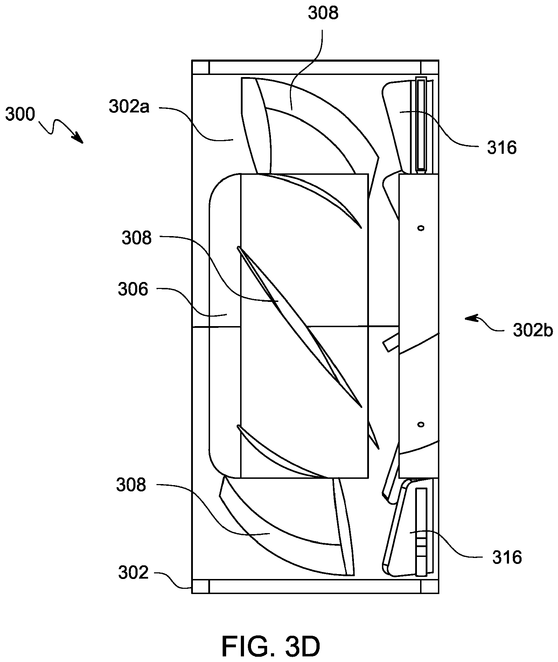

The fan assembly 300 includes a fan housing 302 with an inlet 302a and an outlet 302b, a shroud panel 304, an axial fan 306, fan blades 308, cutout portions 310, fixed members 314, flap members 316, and biasing elements 318. The fan housing 302 holds the components for the fan assembly 300. The axial fan 306 includes fan blades 308 that rotate and pull air in through the inlet 302a, and push air through the outlet 302b. The shroud panel 304 provides a window for air to be pushed through the outlet 302b, and provides the attachment between the axial fan 306 and the flap members 316, fixed members 314, and biasing elements 318. Flap members 316 are attached to fixed members 314 via a biasing element 318. The biasing element 318 is configured to allow the flap members 316 to pivot between an open position (shown in FIG. 3A and FIG. 3C) and a closed position (shown in FIG. 3B and FIG. 3D). When the axial fan 306 powers the rotation of the fan blades 308, the air pressure flowing through the fan assembly 300 causes the flap members 316 to open outwards (as shown in FIG. 3A and FIG. 3C). If the axial fan 306 is not powered for some reason, the biasing element 318 causes the flap members 316 to rotate into a closed position preventing the flow of air into or out of the fan assembly 300 (as shown in FIG. 3B and FIG. 3D).

In greater detail, FIG. 3A shows the flap members 316 extending outwards from the pressure of air flowing through the fan assembly 300. In this embodiment, there are nine flap members 316, but there can be more or fewer flap members 316 so long as there is at least one. In this embodiment, the flap members 316 are arranged in a circular or annular pattern around the axial fan 306 in the same pattern as the fan blades 308 (shown in greater detail in FIG. 3C).

Referring to FIG. 3B, the fan assembly 300 is shown at the same angle as the fan assembly 300 in FIG. 3A, but FIG. 3B shows the flap members 316 in the closed position. When there is no airflow out of the fan assembly 300, the flap members 316 pivot to a closed position via the biasing elements 318. The biasing elements 318 contain a spring component, which causes the flap members 316 to snap shut when the axial fan 306 is not operational, or when the axial fan fails to provide a threshold amount of airflow. The flap members 316 also fall shut in response to airflow from the outlet 302b to the inlet 302a. The biasing elements 318 are configured to maintain the flap members 316 in the closed position until the axial fan 306 provides a threshold amount of airflow.

In this closed position, the flap members 316 are configured to cover cutout portions 310 on the shroud panel 304. This blocks air from passing through the fan assembly 300. Additionally, as discussed above, either the flap members 316 or the fan housing 302 can contain sealing elements which provide an airtight cover for the fan assembly 300. For example, a sealing element could be placed on the outside of each flap member 316, on the interior perimeter of the shroud panel 304, on the exterior perimeter of the axial fan 306; or on some combination of the preceding locations. The sealing element can provide additional protection from air flowing in the reverse direction through the fan assembly 300. The sealing element does not need to be completely airtight, and can still allow some air to flow through the reverse direction. However, the sealing element will not allow enough air to flow through so that the axial fan 306 begins to turn in the reverse direction.

Referring now to FIG. 3C, a side perspective view of the fan assembly 300 in the extended or open position is shown. From this angle, it is clear that the fan blades 308 and the flap members 316 can be offset by at least 90 degrees in the open position. This allows the direction of airflow to pass directly through the cutout portions 310 with minimum obstruction from the flap members 316. Therefore, airflow occurs with great efficiency when the flap members 316 are in the open position.

FIG. 3D shows a side perspective of the fan assembly 300 when the flap members 316 are in the closed position. When the flap members 316 are in the closed position, the flap members 316 lie flush with the fan housing 302 to block cutout portions 310.

In server systems or other electronic computing systems, more than one cooling fan may be needed to cool all the system's components. Cooling fans can be placed in parallel structures in a computing system to blow across different components. This allows more system cooling to occur than with individual fans. However, one of the cooling fans in a row of fans can become non-operational. The air current and airflow coming from the other fans can cause a reverse air current through the non-operational fan. This decreases the cooling ability of the fan system and can lead to overheating of electronic components, since the hot air from the overheating components is sucked back into the computing system.

A cooling fan according to the present invention does not allow reverse air current through a non-operational fan. As soon as a cooling fan becomes non-operational, the flap members 316 close, forming a static blade and a seal so that air cannot flow in the reverse direction. Cooling fans according to the present invention can therefore be used in a server system where more than one cooling fan is needed to cool the electronic components. Whenever a cooling fan becomes non-operational, the closed flap members 316 will prevent the creation of a reverse air current and continue to allow maximum cooling of components. Even with one or more cooling fans non-operational, all air will continue to flow in the proper direction and continue to cool off over-heating components.

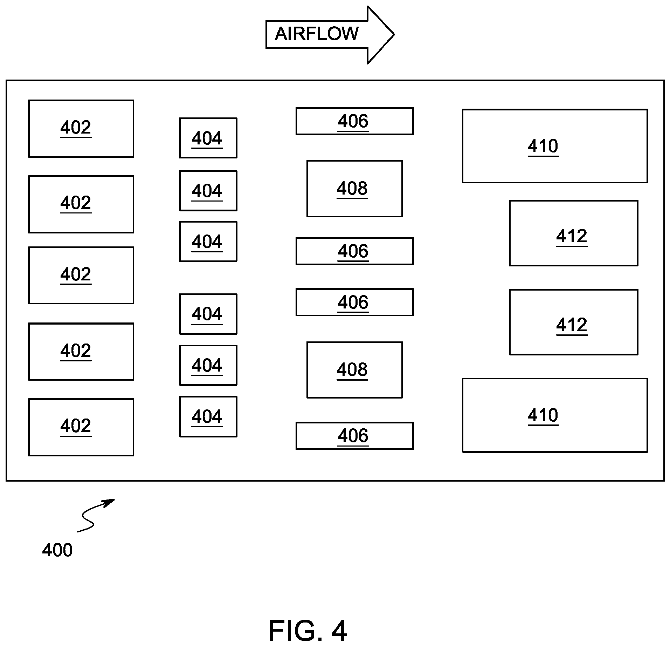

FIG. 4 shows an exemplary configuration of cooling fans in a computer system 400. The computer system 400 includes disk storage units 402, cooling fan assemblies 404, memory modules 406, processing units 408, power supplies 410, and internet connections 412. The processing units 408 and memory modules 406 can have a greater need for cooling than other computer components because these components generate high amounts of heat due to the high volumes of electric signals passing through them. Therefore, the cooling fan assemblies 404 can be placed in a row spanning the width of the computer system 400, and move air in the direction of the memory modules 406 and processing units 408. The airflow can carry heat away from the memory modules 406 and processing units 408 and exit the computer system 400 by flowing over any remaining computer components such as power supplies 410 and internet connections 412. The closing of flap members 316 when any of the cooling fan assemblies 404 become non-operational prevents the flow of hot air in the reverse direction back towards the disk storage units 402.

## Claims

1. A cooling fan assembly (200; 300; 404) comprising:
a housing (202; 302) having an inlet (202a; 302a) and an outlet (202b; 302b), the housing (202; 302) comprising a shroud panel (204; 304) disposed at the outlet (202b; 302b);
an axial fan (206; 306) disposed in the housing (202; 302), the axial fan (206; 306) configured to draw air from the inlet (202a; 302a) to the outlet (202b; 302b); and
wherein the shroud panel (204; 304) comprises a plurality of cutout portions (210; 310) disposed along an airflow path of the axial fan (206; 306), a plurality of fixed members (214; 314) separating the plurality of cutout portions (210; 310), and a plurality of flap members (216; 316), each of the plurality of flap members (216; 316) pivotably attached to one of the plurality of fixed members (214; 314),
wherein each of the plurality of flap members (216; 316) is configured to alternate between at least a first position extending away from the shroud panel (204; 304) and a second position within one of the plurality of cutout portions (210; 310),
wherein at least one spring-loaded structure (218; 318) is configured to maintain the one of the plurality of flap members (216; 316) in the second position when the axial fan (206; 306) fails to supply a threshold amount of airflow, and
wherein the plurality of flap members (216; 316) are configured to extend substantially across an associated one of the plurality of cutout portions (210; 310) while in the second position, and
**characterized in that** at least one spring-loaded structure (218; 318) is configured as a pivot connected between each one of the plurality of flap members (216; 316) and the associated one of the plurality of fixed members (214; 314).

2. The cooling fan assembly (200; 300; 404) of claim 1, wherein in the second position, each one of the plurality of flap members (216; 316) and an associated one of the plurality of fixed members (214; 314) are configured to define a static blade in the shroud panel (204; 304).

3. The cooling fan assembly (200; 300; 404) of claim 1, wherein the plurality of cutout portions (210; 310) extends along the shroud panel (204; 304) in an annular path.

4. The cooling fan assembly (200; 300; 404) of claim 1, wherein at least one of the plurality of flap members (216; 316) or an associated one of the plurality of cutout portions (210; 310) includes one or more sealing elements.

5. The cooling fan assembly (200; 300; 404) of claim 1, wherein each of the plurality of flap members (216; 316) is configured to alternate from the second position to the first position in response to airflow from the inlet (202a; 302a) to the outlet (202b; 302b), and alternate from the first position to the second position in response to airflow from the outlet (202b; 302b) to the inlet (202a; 302a).

6. A computer system (400) comprising:
the cooling fan assembly (200; 300 ; 404) of any one of the preceding claims 1 to 5; and
at least one electronic component (402; 406; 408; 410), wherein the electronic component (402; 406; 408; 410) is configured to need cooling airflow in order to prevent damage to the electronic component (402; 406; 408; 410); and
wherein the at least one cooling fan assembly (200; 300; 404) is further configured to move air across the electronic component (402; 406; 408; 410), wherein the movement of air carries heat away from the electronic component (402; 406; 408; 410).

7. The computer system (400) of claim 6, further comprising a set of cooling fan assemblies (200; 300; 404) configured in parallel and facing a set of electronic components (402; 406; 408; 410), wherein the set of cooling fan assemblies (200; 300; 404) is configured to move air across the set of electronic components (402; 406; 408; 410), wherein the movement of air carries heat away from the set of electronic components (402; 406; 408; 410).

## Patentansprüche

1. Kühlgebläseanordnung (200; 300; 404), mit:
einem Gehäuse (202; 302) mit einem Einlass (202a; 302a) und einem Auslass (202b; 302b), wobei das Gehäuse (202; 302) eine Abdeckplatte (204; 304) aufweist, die am Auslass (202b; 302b) angeordnet ist;
einem Axiallüfter (206; 306), der in dem Gehäuse (202; 302) angeordnet ist, wobei der Axiallüfter (206; 306) so konfiguriert ist, dass er Luft von dem Einlass (202a; 302a) zu dem Auslass (202b; 302b) saugt; und
wobei die Abdeckplatte (204; 304) eine Vielzahl von Ausschnittabschnitten (210; 310), die entlang eines Luftstromweges des Axiallüfters (206; 306) angeordnet sind, eine Vielzahl von festen Elementen (214; 314), die die Vielzahl von Ausschnittabschnitten (210; 310) trennen, und eine Vielzahl von Klappenelementen (216; 316) aufweist, wobei jedes der Vielzahl von Klappenelementen (216; 316) schwenkbar an einem der Vielzahl von festen Elementen (214; 314) angebracht ist,
wobei jedes der Vielzahl von Klappenelementen (216; 316) so konfiguriert ist, dass es zumindest zwischen einer ersten Position, die sich von der Abdeckplatte (204; 304) weg erstreckt, und einer zweiten Position innerhalb eines der Vielzahl von Ausschnittabschnitten (210; 310) wechselt,
wobei mindestens eine federbelastete Struktur (218; 318) so konfiguriert ist, dass sie das eine der mehreren Klappenelemente (216; 316) in der zweiten Position hält, wenn der Axiallüfter (206; 306) nicht einen Schwellenbetrag an Luftstrom liefert, und
wobei die Vielzahl von Klappenelemente (216; 316) so konfiguriert ist, dass sie sich im Wesentlichen über einen zugeordneten der Vielzahl von Ausschnittabschnitten (210; 310) erstrecken, während sie sich in der zweiten Position befinden,
**dadurch gekennzeichnet, dass**
die mindestens eine federbelastete Struktur (218; 318) als ein Drehpunkt konfiguriert ist, der zwischen jedem der Vielzahl von Klappenelementen (216; 316) und dem zugeordneten der Vielzahl von festen Elementen (214; 314) verbunden ist.

2. Kühlgebläseanordnung (200; 300; 404) nach Anspruch 1, wobei in der zweiten Position jedes der Vielzahl von Klappenelemente (216; 316) und ein zugeordnetes der Vielzahl von festen Elementen (214; 314) so konfiguriert sind, dass sie eine statische Schaufel in der Abdeckplatte (204; 304) definieren.

3. Kühlgebläseanordnung (200; 300; 404) nach Anspruch 1, wobei die Vielzahl von Ausschnittabschnitten (210; 310) sich entlang der Abdeckplatte (204; 304) in einem ringförmigen Pfad erstreckt.

4. Kühlgebläseanordnung (200; 300; 404) nach Anspruch 1, wobei zumindest eines der Vielzahl von Klappenelementen (216; 316) oder ein zugeordnetes der Vielzahl von Ausschnittabschnitten (210; 310) ein oder mehrere Dichtungselemente beinhaltet.

5. Kühlgebläseanordnung (200; 300; 404) nach Anspruch 1, wobei jedes der Vielzahl von Klappenelementen (216; 316) so konfiguriert ist, dass es als Reaktion auf einen Luftstrom vom Einlass (202a; 302a) zum Auslass (202b; 302b) von der zweiten Position zur ersten Position wechselt und als Reaktion auf einen Luftstrom vom Auslass (202b; 302b) zum Einlass (202a; 302a) von der ersten Position zur zweiten Position wechselt.

6. Computersystem (400) mit:
der Kühlgebläseanordnung (200; 300; 404) nach einem der vorhergehenden Ansprüche 1 bis 5; und
mindestens einer elektronischen Komponente (402; 406; 408; 410), wobei die elektronische Komponente (402; 406; 408; 410) so konfiguriert ist, dass sie einen Kühlluftstrom benötigt, um eine Beschädigung der elektronischen Komponente (402; 406; 408; 410) zu verhindern; und
wobei die mindestens eine Kühlgebläseanordnung (200; 300; 404) ferner so konfiguriert ist, dass sie Luft über die elektronische Komponente (402; 406; 408; 410) bewegt, wobei die Bewegung der Luft Wärme von der elektronischen Komponente (402; 406; 408; 410) abführt.

7. Computersystem (400) nach Anspruch 6, ferner mit einem Satz an Kühlgebläseanordnungen (200; 300; 404), die parallel konfiguriert sind und einem Satz elektronischer Komponenten (402; 406; 408; 410) zugewandt sind, wobei der Satz von Kühlgebläseanordnungen (200; 300; 404) so konfiguriert ist, dass er Luft über den Satz elektronischer Komponenten (402; 406; 408; 410) bewegt, wobei die Bewegung von Luft Wärme von dem Satz elektronischer Komponenten (402; 406; 408; 410) abführt.

## Revendications

1. Ensemble ventilateur de refroidissement (200 ; 300; 404) comprenant :
un logement (202 ; 302) présentant une entrée (202a ; 302a) et une sortie (202b ; 302b), le logement (202 ; 302) comprenant un panneau de déflecteur (204 ; 304) disposé à la sortie (202b ; 302b) ;
un ventilateur axial (206 ; 306) disposé dans le logement (202 ; 302), le ventilateur axial (206 ; 306) étant configuré pour aspirer de l'air depuis l'entrée (202a ; 302a) vers la sortie (202b ; 302b) ; et
dans lequel le panneau de déflecteur (204 ; 304) comprend une pluralité de parties découpées (210; 310) disposées le long d'un trajet d'écoulement d'air du ventilateur axial (206 ; 306), une pluralité d'éléments fixes (214 ; 314) séparant la pluralité de parties découpées (210; 310), et une pluralité d'éléments de volet (216 ; 316), chacun de la pluralité d'éléments de volet (216 ; 316) étant fixé de manière pivotante à l'un de la pluralité d'éléments fixes (214 ; 314),
dans lequel chacun de la pluralité d'éléments de volet (216 ; 316) est configuré pour alterner entre au moins une première position s'étendant à l'écart du panneau de déflecteur (204 ; 304) et une seconde position à l'intérieur de l'une de la pluralité de parties découpées (210 ; 310),
dans lequel au moins une structure à ressort (218 ; 318) est configurée pour maintenir celui de la pluralité d'éléments de volet (216 ; 316) dans la seconde position quand le ventilateur axial (206 ; 306) ne parvient pas à fournir une quantité seuil d'écoulement d'air, et
dans lequel la pluralité d'éléments de volet (216 ; 316) sont configurés pour s'étendre sensiblement à travers celle associée de la pluralité de parties découpées (210 ; 310) lorsqu'ils sont dans la seconde position, et **caractérisé en ce qu'**au moins une structure à ressort (218 ; 318) est configurée sous la forme d'un pivot relié entre chacun de la pluralité d'éléments de volet (216 ; 316) et celui associé de la pluralité d'éléments fixes (214 ; 314).

2. Ensemble ventilateur de refroidissement (200 ; 300 ; 404) selon la revendication 1, dans lequel dans la seconde position, chacun de la pluralité d'éléments de volet (216 ; 316) et celui associé de la pluralité d'éléments fixes (214 ; 314) sont configurés pour définir une lame statique dans le panneau de déflecteur (204 ; 304).

3. Ensemble ventilateur de refroidissement (200 ; 300 ; 404) selon la revendication 1, dans lequel la pluralité de parties découpées (210; 310) s'étendent le long du panneau de déflecteur (204 ; 304) dans un trajet annulaire.

4. Ensemble ventilateur de refroidissement (200 ; 300 ; 404) selon la revendication 1, dans lequel au moins l'un de la pluralité d'éléments de volet (216 ; 316) ou celle associée de la pluralité de parties découpées (210 ; 310) inclut un ou plus d'éléments d'étanchéité.

5. Ensemble ventilateur de refroidissement (200 ; 300 ; 404) selon la revendication 1, dans lequel chacun de la pluralité d'éléments de volet (216 ; 316) est configuré pour alterner de la seconde position à la première position en réponse à un écoulement d'air allant de l'entrée (202a ; 302a) vers la sortie (202b ; 302b), et alterner de la première position à la seconde position en réponse à un écoulement d'air allant de la sortie (202b ; 302b) vers l'entrée (202a ; 302a).

6. Système informatique (400) comprenant :
l'ensemble ventilateur de refroidissement (200; 300; 404) selon l'une quelconque des revendications 1 à 5 précédentes ; et
au moins un composant électronique (402 ; 406 ; 408; 410), dans lequel le composant électronique (402 ; 406 ; 408 ; 410) est configuré pour avoir besoin d'un écoulement d'air de refroidissement afin d'éviter d'endommager le composant électronique (402 ; 406 ; 408 ; 410) ; et
dans lequel le au moins un ensemble ventilateur de refroidissement (200; 300; 404) est configuré en outre pour déplacer de l'air à travers le composant électronique (402 ; 406 ; 408 ; 410), dans lequel le déplacement de l'air évacue la chaleur du composant électronique (402 ; 406 ; 408 ; 410).

7. Système informatique (400) selon la revendication 6, comprenant en outre un ensemble d'ensembles ventilateur de refroidissement (200 ; 300; 404) configurés en parallèle et faisant face à un ensemble de composants électroniques (402 ; 406 ; 408 ; 410), dans lequel l'ensemble d'ensembles ventilateur de refroidissement (200 ; 300 ; 404) est configuré pour déplacer de l'air à travers l'ensemble de composants électroniques (402 ; 406 ; 408 ; 410), dans lequel le déplacement de l'air évacue la chaleur de l'ensemble de composants électroniques (402 ; 406 ; 408 ; 410).
